# EUROPEAN PATENT APPLICATION

(11) **EP 4 852 662 A1**
(43) Date of publication of application: **09.12.2026**
(21) Application number: 25216132.8
(22) Date of filing: 17.11.2025
(51) Int. Cl.: H10F 19/90, H10F 77/20

(54) **BACK-CONTACT SOLAR CELL, TANDEM SOLAR CELL, AND PHOTOVOLTAIC MODULE**

(30) Priority: 03.06.2025 CN 202510727112
(71) Applicant: Jinko Solar (Haining) Co., Ltd., Haining City, Zhejiang 314415 (CN)
(72) Inventor: WANG, Luchuang, Jiaxing, 314415 (CN); PENG, Yingying, Jiaxing, 314415 (CN); FANG, Sheng, Jiaxing, 314415 (CN)
(74) Representative: Rösler Rasch van der Heide & Partner

(57) **Abstract**

Provided are a back-contact solar cell, a tandem solar cell, and a photovoltaic module, which relate to the field of photovoltaic technology. The back-contact solar cell includes a first finger, an edge solder joint, and a middle solder joint. The edge solder joint is located at an edge of the back-contact solar cell and arranged on the first finger. A plurality of the middle solder joints are arranged between two adjacent edge solder joints in the first direction, and are respectively arranged on the corresponding first fingers. The edge solder joint includes a first end facing the middle solder joint and a second end away from the middle solder joints in the first direction. The first end is electrically connected to the middle solder joint adjacent thereto through a first connecting wire, the second end is electrically connected to the first finger adjacent thereto through a second connecting wire, and a width of the second connecting wire is greater than a width of the first connecting wire. The above design improves the current transmission capability and current transmission efficiency of the solar cell, thereby improving the reliability and photoelectric conversion efficiency of the solar cell.

## Description

### TECHNICAL FIELD

The present disclosure relates to the field of photovoltaic technology, and in particular, to a back-contact solar cell, a tandem solar cell, and a photovoltaic module.

### BACKGROUND

A solar cell serves to convert solar energy into electrical energy. The front surface of a back-contact solar cell has no grid lines shading, so as to reduce the light-shading loss caused by the grid lines. At present, the current collection and transmission performance of the back-contact solar cell is poor, thereby affecting the photoelectric conversion efficiency of the back-contact solar cell.

### SUMMARY

In view of this, a back-contact solar cell, a tandem solar cell, and a photovoltaic module are provided herein for facilitating solution of the problem of poor current collection and transmission performance of the back-contact solar cells in the existing technology.

In a first aspect, one or more embodiments of the present disclosure provides a back-contact solar cell, including a first finger, an edge solder joint, and a middle solder joint. A plurality of the first fingers are arranged in a first direction. The edge solder joint is located at an edge of the back-contact solar cell and arranged on the first finger. A plurality of the middle solder joints are arranged between two adjacent edge solder joints in the first direction, and are respectively arranged on the corresponding first fingers. The edge solder joint includes a first end facing the middle solder joint and a second end away from the middle solder joints in the first direction. The first end is electrically connected to the middle solder joint adjacent thereto through a first connecting wire, the second end is electrically connected to the first finger adjacent thereto through a second connecting wire, and a width of the second connecting wire is greater than a width of the first connecting wire.

In a second aspect, one or more embodiments of the present disclosure provides a tandem solar cell, including a crystalline silicon bottom cell and a perovskite top cell. Tcrystalline silicon bottom cell includes the back-contact solar cell described above, and the perovskite top cell is electrically connected to the crystalline silicon bottom cell.

In a third aspect, one or more embodiments of the present disclosure provides a photovoltaic module, including a cover plate, an encapsulation layer, and a solar cell string. The solar cell string includes a plurality of the back-contact solar cells described above, or the solar cell string includes a plurality of the tandem solar cells described above.

The present disclosure has the following beneficial effects: the first end of the edge solder joint is electrically connected to the middle solder joint adjacent thereto through the first connecting wire. When there is a poor soldering problem, such as false soldering, etc., between the middle solder joint and the solder strip, the current collected to the middle solder joint is transmitted to the edge solder joint through the first connecting wire, and then transmitted to the solder strip through the edge solder joint, so as to ensure the normal and stable transmission of current, thereby improving the reliability of current collection and transmission at the edge region of the back-contact solar cell. The second end of the edge solder joint is connected to the first finger adjacent thereto through the second connecting wire, so that the current in the first finger is transmitted to the edge solder joint through the second connecting wire to realize output. The second connecting wire is directly electrically connected to the first finger, so that it is unnecessary to provide a corresponding solder joint at the first finger, reducing the current transmission loss, while improving the current collection efficiency at the edge region of the back-contact solar cell, thereby improving the photoelectric conversion efficiency of the back-contact solar cell. The width of the second connecting wire is larger, so as to reduce the current transmission loss, improve the current collection efficiency, and enhance the mechanical property of the second connecting wire, thereby improving the reliability of the back-contact solar cell.

It should be understood that the general description above and the detailed description in the following are merely illustrative, and cannot limit the present disclosure.

### BRIEF DESCRIPTION OF DRAWINGS

In order to better illustrate the technical solutions in embodiments of the present disclosure, the drawings used in the description of embodiments are briefly described as below.
FIG. 1 is a schematic diagram of the appearance of the back-contact solar cell according to one or more embodiments of the present disclosure;
FIG. 2 is a partial schematic structural diagram of the back-contact solar cell according to one or more embodiments of the present disclosure;
FIG. 3 is a partial enlarged view of FIG. 2;
FIG. 4 is a partial schematic structural diagram of a back-contact solar cell according to other one or more embodiments of the present disclosure;
FIG. 5 is a partial schematic structural diagram of a back-contact solar cell according to still other one or more embodiments of the present disclosure;
FIG. 6 is a schematic diagram of the tandem solar cell according to one or more embodiments of the present disclosure; and
FIG. 7 is a schematic structural diagram of the photovoltaic module according to one or more embodiments of the present disclosure.

### Reference signs:

1000 - photovoltaic module; 100 - solar cell string; 10 - back-contact solar cell; 10a - first side edge; 10b - second side edge; 10c - third side edge; 10d - fourth side edge; 10e - first corner part; 10f - second corner part; 10g - third corner part; 10h - fourth corner part; 11 - first finger; 111 - first connecting sub-segment; 112 - second connecting sub-segment; 113 - third connecting sub-segment; 114 - third insulation space; 115 - fourth insulation space; 12 - second finger; 121 - first insulation space; 122 - second insulation space; 123 - first part; 124 - second part; 125 - third part; 126 - fourth part; 13 - edge solder joint; 131 - first end; 132 - second end; 133 - third end; 134 - fourth end; 135 - first extension part; 136 - second extension part; 14 - middle solder joint; 15 - first connecting wire; 16 - second connecting wire; 17 - third connecting wire; 200 - first cover plate; 300 - second cover plate; 400 - first encapsulation layer; 500 - second encapsulation layer; 20 - tandem solar cell; 21 - crystalline silicon bottom cell; 22 - perovskite top cell.

### DESCRIPTION OF EMBODIMENTS

In order to better understand the technical solutions of the present disclosure, embodiments of the present disclosure are described in detail below in conjunction with the drawings.

The terms used in embodiments of the present disclosure are only for the purpose of describing specific embodiments, and are not intended to limit the present disclosure. As used in embodiments of the present disclosure and the appended claims, the singular forms "alan", "said", and "the" are intended to include the plural forms as well, unless the context clearly indicated otherwise.

It should be understood that the term "and/or" used herein is merely an association relationship describing an associated object, and indicates that there may be three relationships. For example, A and/or B, and may indicate: only A, both A and B, and only B. In addition, the character "/" herein generally indicates that the related objects before and after the character present an "or" relationship.

A back-contact solar cell serves to convert solar energy into electrical energy, and the front surface of which has no grid lines shading, so as to reduce the light-shading loss caused by the grid lines. At present, the current collection and transmission performance of the back-contact solar cell is poor, thereby affecting the photoelectric conversion efficiency and the reliability of the back-contact solar cell.

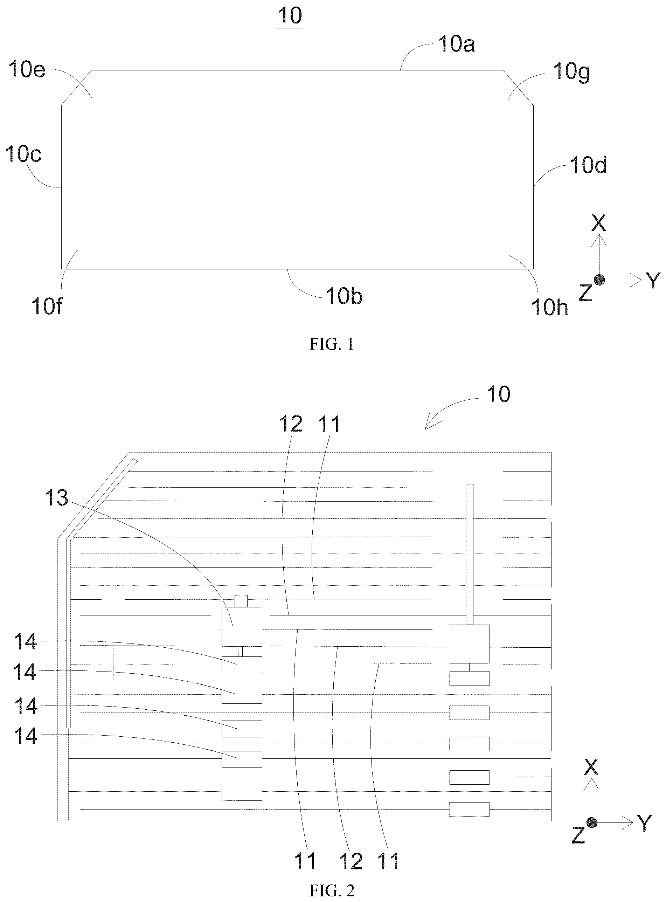

As shown in FIG. 1, one or more embodiments of the present disclosure provides a back-contact solar cell 10. The back-contact solar cell 10 is approximately rectangular in shape, and has a first side edge 10a and a second side edge 10b in a first direction X and a third side edge 10c and a fourth side edge 10d in a second direction Y. There are a first corner part 10e at the junction of the first side edge 10a and the third side edge 10c, a second corner part 10f at the junction of the second side edge 10b and the third side edge 10c, a third corner part 10g at the junction of the first side edge 10a and the fourth side edge 10d, and a fourth corner part 10h at the junction of the second side edge 10b and the fourth side edge 10d. The first direction X intersects with the second direction Y. The first direction X may be the width direction of the back-contact solar cell 10, and the second direction Y may be the length direction of the back-contact solar cell 10. Both the first direction X and the second direction Y are perpendicular to the third direction Z, and the third direction Z may be the thickness direction of the back-contact solar cell 10.

In one or more embodiments, the back-contact solar cell 10 may be a busbarless back-contact solar cell.

The back-contact solar cell may be a half-cut cell, a three-cut cell, a four-cut cell, or an eight-cut cell obtained by cutting an entire solar cell. That is, the solar cell is a cut cell. Alternatively, the back-contact solar cell described above is an entire solar cell.

As shown in FIG. 2, the back-contact solar cell 10 includes a first finger 11, a second finger 12, an edge solder joint 13, and a middle solder joint 14. A plurality of the first fingers 11 and a plurality of the second fingers 12 are arranged alternately in the first direction X. The first finger 11 and the second finger 12 are metal electrodes of the back-contact solar cell 10. The first finger 11 serves as a positive electrode of the back-contact solar cell 10, or the first finger 11 serves as a negative electrode of the back-contact solar cell 10. The electrode polarity of the second finger 12 is opposite to that of the first finger 11. Both the first finger 11 and the second finger 12 are electrically connected to a solder strip (not shown in this figure), enabling the solder strip to output the electrical energy generated by the back-contact solar cell 10.

Further referring to FIG. 1, the edge solder joint 13 is located at the edge of the back-contact solar cell 10 and arranged on the first finger 11. The edge solder joint 13 is electrically connected to the corresponding first finger 11, and serves to be connected to a solder strip (not shown in this figure). The edge solder joint 13 can be understood as the solder joint closest to the side edge of the back-contact solar cell 10. In some embodiments, the edge solder joints 13 are arranged respectively at the first corner part 10e, the second corner part 10f, the third corner part 10g, and the fourth corner part 10h.

A plurality of the middle solder joints 14 are arranged in the first direction X between two adjacent edge solder joints 13. The plurality of the middle solder joints 14 are respectively arranged at the corresponding first fingers 11, and each middle solder joint 14 is electrically connected to the corresponding first finger 11. The middle solder joint 14 also serves to be connected to the solder strip. That is, the edge solder joints 13 and the middle solder joints 14 arranged in the first direction X are connected to the same solder strip.

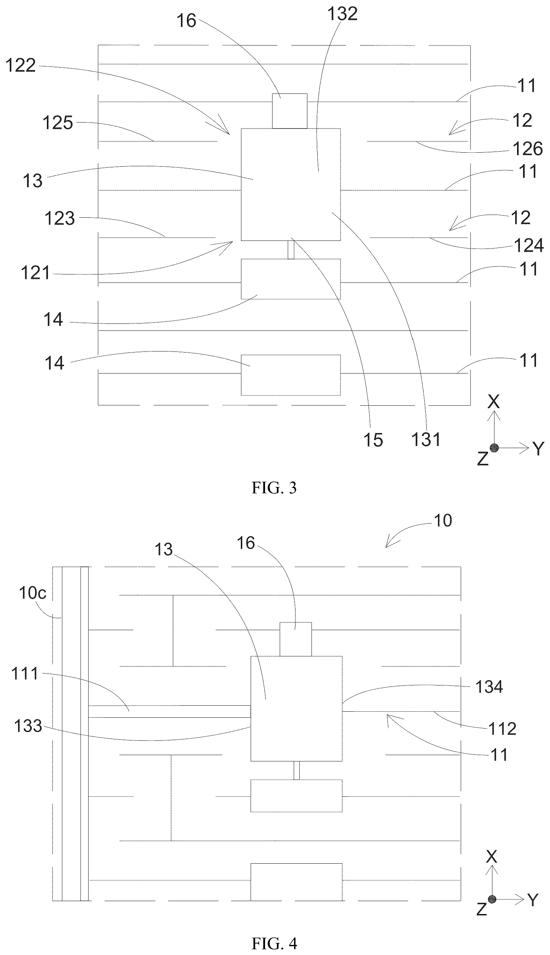

As shown in FIG. 3, the edge solder joint 13 includes a first end 131 facing the middle solder joint 14 and a second end 132 away from the middle solder joint 14 in the first direction X. The first end 131 is electrically connected to the middle solder joint 14 adjacent thereto through a first connecting wire 15. The first connecting wire 15 is arranged in the first direction X. The middle solder joint 14 adjacent to the edge solder joint 13 is the middle solder joint 14 closest to the first end 131 of the edge solder joint 13 among a plurality of the middle solder joints 14. That is, the edge solder joint 13 is electrically connected to one middle solder joint 14 adjacent thereto through the first connecting wire 15, so that current is transmitted between two adjacent first fingers 11 through the first connecting wire 15.

The second end 132 is electrically connected to the first finger 11 adjacent thereto through a second connecting wire 16. The second connecting wire 16 is arranged in the first direction X. The first finger 11 adjacent to the edge solder joint 13 is the first finger 11 closest to the second end 132 of the edge solder joint 13 among a plurality of the first fingers 11. That is, the edge solder joint 13 is electrically connected to one first finger 11 adjacent thereto through the second connecting wire 16. There is no solder joint provided at the first finger 11 adjacent to the second end 132, thus the second connecting wire 16 is directly electrically connected to the first finger 11, thereby enabling current to be transmitted between two adjacent first fingers 11.

The second finger 12 is cut off to form a first insulation space 121 and a second insulation space 122. The first insulation space 121 and the second insulation space 122 are arranged in the first direction X. The second finger 12 includes a first part 123, a second part 124, a third part 125, and a fourth part 126. The first part 123 and the second part 124 are spaced apart in the second direction Y. The first insulation space 121 is located between the first part 123 and the second part 124. The third part 125 and the fourth part 126 are spaced apart in the second direction Y, and the second insulation space 122 is located between the third part 125 and the fourth part 126.

The first connecting wire 15 passes through the first insulation space 121 in the first direction X to realize electrical connection between the edge solder joint 13 and the middle solder joint 14 adjacent thereto. A part of the structure of the first connecting wire 15 is located within the first insulation space 121 and has a certain interval with the first part 123 and the second part 124 of the second finger 12. The second connecting wire 16 passes through the second insulation space 122 to realize the electrical connection between the edge solder joint 13 and the first finger 11 adjacent thereto. A part of the structure of the second connecting wire 16 is located within the second insulation space 122 and has a certain interval with the third part 125 and the fourth part 126 of the second finger 12. The first insulation space 121 realizes insulation between the first connecting wire 15 and the second finger 12, and the second insulation space 122 realizes insulation between the second connecting wire 16 and the second finger 12, thereby reducing the possibility of short circuit of the back-contact solar cell 10 caused by connection of the first connecting wire 15 and the second connecting wire 16 with the second finger 12.

Both the first connecting wire 15 and the second connecting wire 16 are formed by printing metal paste and then drying and sintering. The width of the second connecting wire 16 (i.e., the size of the second connecting wire 16 in the second direction Y) is greater than the width of the first connecting wire 15 (i.e., the size of the first connecting wire 15 in the second direction Y).

The back-contact solar cell 10 in embodiments of the present disclosure adopts (OBB, 0-Busbar) technology, enabling the solder strip to be directly connected to the finger. Since it is unnecessary to provide a busbar, the consumption of metal paste is reduced, thereby lowering the production cost of the back-contact solar cell 10, while reducing the light-shading area of the grid lines, and improving the photoelectric conversion efficiency of the back-contact solar cell 10.

The first end 131 of the edge solder joint 13 is electrically connected to the middle solder joint 14 adjacent thereto through the first connecting wire 15. When there is a poor soldering problem, such as false soldering, etc., between the middle solder joint 14 and the solder strip, the current collected to the middle solder joint 14 is transmitted to the edge solder joint 13 through the first connecting wire 15, and then transmitted to the solder strip through the edge solder joint 13, so as to ensure the normal and stable transmission of current, thereby improving the reliability of current collection and transmission at the edge region of the back-contact solar cell 10, and further improving the electrical property of the back-contact solar cell 10. The second end 132 of the edge solder joint 13 is connected to the first finger 11 adjacent thereto through the second connecting wire 16, so that the current in the first finger 11 is transmitted to the edge solder joint 13 through the second connecting wire 16 to realize output. The second connecting wire 16 is directly electrically connected to the first finger 11, so that it is unnecessary to provide a corresponding solder joint at the first finger 11, reducing the current transmission loss, while improving the current collection efficiency at the edge region of the back-contact solar cell 10, thereby improving the photoelectric conversion efficiency of the back-contact solar cell 10. In addition, the width of the second connecting wire 16 is relatively large, and greater than the width of the first connecting wire 15, so as to reduce the current transmission loss, improve the current collection efficiency, and enhance the mechanical property of the second connecting wire 16 to reduce the possibility of breakage of the second connecting wire 16 during the production and operation of the back-contact solar cell 10 to provide a stable and reliable transmission channel for current, thereby improving the reliability of the back-contact solar cell 10.

Accordingly, the back-contact solar cell 10 according embodiments of the present disclosure, by providing the first connecting wire 15 and the second connecting wire 16 electrically connected to the edge solder joint 13, improves the current transmission capability and the current transmission efficiency of the back-contact solar cell 10, thus improves the electrical properties of the back-contact solar cell 10, and further improves the reliability and the photoelectric conversion efficiency of the back-contact solar cell 10, thereby realizing the normal and stable operation of the back-contact solar cell 10.

In some embodiments, the second connecting wire is directly connected to the solder strip, that is, the second connecting wire is alloyed with the solder strip, enabling the current in the second connecting wire to be directly transmitted to the solder strip, thereby shortening the current transmission path, improving the current transmission efficiency, and further improving the photoelectric conversion efficiency of the back-contact solar cell. In addition, the contact area between the solder strip and the back-contact solar cell is increased, thereby improving the stability and reliability of the connection between the solder strip and the back-contact solar cell.

As shown in FIG. 3, in one or more embodiments, the width W1 of the first connecting wire 15 satisfies: 5 µm ≤ W1 ≤ 20 µm, and the width W2 of the second connecting wire 16 satisfies: 100 µm ≤ W1 ≤ 300 µm.

The width W1 of the first connecting wire 15 may be 5 µm, 6 µm, 8 µm, 10 µm, 12 µm, 14 µm, 16 µm, 18 µm or 20 µm, or other value within the above range. If the first connecting wire 15 has a too small width, its resistance is increased, which affects the transmission efficiency of the current between the edge solder joint 13 and the middle solder joint 14, and reduces the mechanical property of the first connecting wire 15, resulting in a reduced strength that lead to the first connecting wire 15 being prone to breakage during soldering, encapsulation and other processes, to cause adamaged current transmission path to be, thereby affecting the reliability of the back-contact solar cell 10. If the first connecting wire 15 has a too large width, the amount of the metal paste required for preparing the first connecting wire 15 is increased to rise the preparation cost of the back-contact solar cell 10, while the light-shading area of the first connecting wire 15 is increased to increase the light-shading loss caused by the first connecting wire 15, thereby affecting the photoelectric conversion efficiency of the back-contact solar cell 10. Therefore, by limiting the width of the first connecting wire 15 to 5 µm to 20 µm, the preparation cost of the back-contact solar cell 10 is reduced, and the photoelectric conversion efficiency of the back-contact solar cell 10 is ensured, while the mechanical property and the electrical property of the first connecting wire 15 are improved, and stable and reliable current transmission is realized, thereby improving the reliability of the back-contact solar cell 10.

The width W2 of the second connecting wire 16 may be 100 µm, 120 µm, 140 µm, 160 µm, 180 µm, 200 µm, 220 µm, 240 µm, 260 µm, 280 µm or 300 µm, or other value within the above range. The width of the second connecting wire 16 is much greater than the width of the first connecting wire 15. By limiting the width of the second connecting wire 16 to 100 µm to 300 µm, the resistance of the second connecting wire 16 is reduced effectively to realize efficient current transmission, thereby improving the effect of current collection at the edge region of the back-contact solar cell 10, reducing the current loss at the edge region of the back-contact solar cell 10, and enabling the current to be more uniformly distributed, thereby reducing the hot spot risk of the back-contact solar cell 10, suppressing the potential-induced degradation risk, and improving the photoelectric conversion efficiency of the back-contact solar cell 10. In addition, since the second connecting wire 16 has a larger width, the mechanical property of the second connecting wire 16 is improved, reducing the possibility of breakage under a stress such as soldering pressure, etc., thereby improving the reliability of the back-contact solar cell 10.

Accordingly, by limiting the widths of the first connecting wire 15 and the second connecting wire 16, the electrical property of the back-contact solar cell 10 is improved, while the amount of metal paste is saved and the production cost of the back-contact solar cell 10 is reduced.

In some other embodiments, the width W1 of the first connecting wire 15 satisfies: 5 µm ≤ W1 ≤ 20 µm, or the width W2 of the second connecting wire 16 satisfies: 100 µm ≤ W2 ≤ 300 µm.

As shown in FIG. 4, in which taking the third side edge 10c as an example to schematically show the edge of the back-contact solar cell 10. In one or more embodiments, the first finger 11 connected to the edge solder joint 13 includes a first connecting sub-segment 111 and a second connecting sub-segment 112. The edge solder joint 13 includes a third end 133 facing the edge of the back-contact solar cell 10 and a fourth end 134 away from the edge of the back-contact solar cell 10 in the second direction Y. The first connecting sub-segment 111 is located at a side of the third end 133 and extends in the second direction Y to the edge of the back-contact solar cell 10. The second connecting sub-segment 112 is located at a side of the fourth end 134 and extends in the second direction Y away from the first connecting sub-segment 111. The width of the first connecting sub-segment 111 (i.e., the size of the first connecting sub-segment 111 in the first direction X) is greater than the width of the second connecting sub-segment 112 (i.e., the size of the second connecting sub-segment 112 in the first direction X).

The first connecting sub-segment 111 serves to collect the current at the edge region of the back-contact solar cell 10. The first connecting sub-segment 111 is electrically connected to the edge solder joint 13 to transmit the collected current to the edge solder joint 13. The second connecting sub-segment 112 serves to collect the current at a side of the edge solder joint 13 away from the first connecting sub-segment 111. The second connecting sub-segment 112 is electrically connected to the edge solder joint 13 to transmit the collected current to the edge solder joint 13. The width of the first connecting sub-segment 111 is greater than the width of the second connecting sub-segment 112. By increasing the width of the first connecting sub-segment 111, the current transmission and collection capability of the first connecting sub-segment 111 is improved, thereby enabling the current at the edge region of the back-contact solar cell 10 to be effectively collected to reduce the current loss at the edge region of the back-contact solar cell 10, and enabling the current to be more uniformly distributed, thereby reducing the hot spot risk of the back-contact solar cell 10, suppressing the potential-induced degradation risk, and improving the photoelectric conversion efficiency of the back-contact solar cell 10.

Also as shown in FIG. 4, in one or more embodiments, the width W3 of the first connecting sub-segment 111 satisfies: 100 µm ≤ W3 ≤ 350 µm, and the width W4 of the second connecting sub-segment 112 satisfies: 5 µm ≤ W4 ≤ 20 µm.

The width W3 of the first connecting sub-segment 111 may be 100 µm, 120 µm, 140 µm, 160 µm, 180 µm, 200 µm, 220 µm, 240 µm, 260 µm, 280 µm, 300 µm, 320 µm, 340 µm, or 350 µm, or other value within the above range. If the first connecting sub-segment 111 has a too small width, it is difficult to effectively collect and transmit the current at the edge region of the back-contact solar cell 10, resulting in the current loss at the edge region of the back-contact solar cell 10, thereby affecting the photoelectric conversion efficiency and reliability of the back-contact solar cell 10. If the first connecting sub-segment 111 has a too large width, the amount of the metal paste required for preparing the first finger 11 is increased to rise the preparation cost of the back-contact solar cell 10, while the light-shading area of the first finger 11 is increased to increase the light-shading loss caused by the first connecting wire 15, thereby affecting the photoelectric conversion efficiency of the back-contact solar cell 10. Therefore, by designing the width of the first connecting sub-segment 111 to be 100 µm to 350 µm, the current collection and transmission capability of the first connecting sub-segment 111 is improved, while the light-shading area of the first connecting sub-segment 111 is reduced, thereby improving the photoelectric conversion efficiency of the back-contact solar cell 10 and reducing the production cost thereof.

The width W4 of the second connecting sub-segment 112 may be 5 µm, 6 µm, 8 µm, 10 µm, 12 µm, 14 µm, 16 µm, 18 µm or 20 µm, or other value within the above range. By limiting the width of the second connecting sub-segment 112, the stable transmission of current through the second connecting sub-segment 112 is ensured, while the light-shading loss of the second connecting sub-segment 112 is reduced, thereby improving the photoelectric conversion efficiency of the back-contact solar cell 10.

In some other embodiments, the width W3 of the first connecting sub-segment 111 satisfies: 100 µm ≤ W3 ≤ 350 µm, or the width W4 of the second connecting sub-segment 112 satisfies: 5 µm ≤ W4 ≤ 20 µm.

Also as shown in FIG. 4, in one or more embodiments, the length L1 of the first connecting sub-segment 111 (i.e., the size of the first connecting sub-segment 111 in the second direction Y) satisfies: 4 mm ≤ L1 ≤ 6 mm. For example, L1 may be 4 mm, 4.2 mm, 4.4 mm, 4.6 mm, 4.8 mm, 5 mm, 5.2 mm, 5.4 mm, 5.6 mm, 5.8 mm, or 6 mm, or other value within the above range. If the first connecting sub-segment 111 has a too small length, the first connecting sub-segment 111 is prone to breakage due to stress concentration, affecting the current collection and transmission capability of the first connecting sub-segment 111. If the first connecting sub-segment 111 has a too large length, the current transmission path is increased to rise the resistance loss, affecting the electrical properties of the back-contact solar cell 10. Therefore, by designing the length of the first connecting sub-segment 111 to be 4 mm to 6 mm, the mechanical property of the first connecting sub-segment 111 is ensured, while the current transmission path is shorten, and the resistance loss is reduced, thereby improving the efficiency and stability of current transmission of the first connecting sub-segment 111.

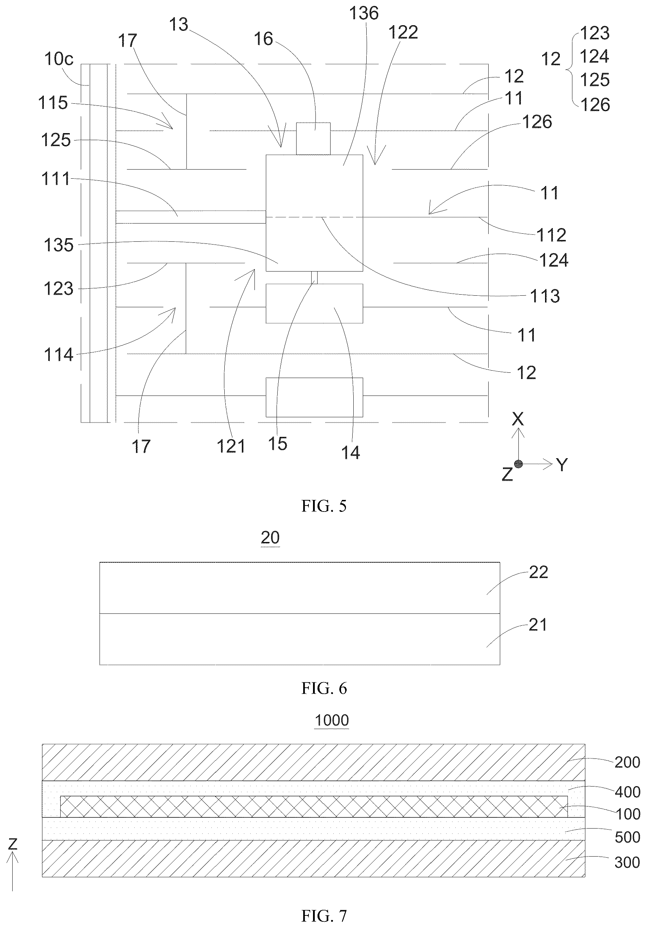

As shown in FIG. 5, in one or more embodiments, the first finger 11 connected to the edge solder joint 13 includes a third connecting sub-segment 113. In the second direction Y, the third connecting sub-segment 113 is connected between the first connecting sub-segment 111 and the second connecting sub-segment 112. The third connecting sub-segment 113 is connected to the edge solder joint 13, and a projection of the third connecting sub-segment 113 in the third direction Z is located within the edge solder joint 13. The width of the third connecting sub-segment 113 is equal to the width of the first connecting sub-segment 111, or the width of the third connecting sub-segment 113 is equal to the width of the second connecting sub-segment 112.

The edge solder joint 13 covers the third connecting sub-segment 113. That is, the edge solder joint 13 is formed on the third connecting sub-segment 113. The edge solder joint 13 is electrically connected to the third connecting sub-segment 113 to realize electrical connection of the edge solder joint 13 with the first connecting sub-segment 111 and the second connecting sub-segment 112. In some embodiments, the width of the third connecting sub-segment 113 is equal to the width of the second connecting sub-segment 112. That is, the width of the third connecting sub-segment 113 is less than the width of the first connecting sub-segment 111, thereby saving the amount of metal paste and reducing the production cost of the back-contact solar cell 10.

In some other embodiments, the width of the third connecting sub-segment 113 is equal to the width of the first connecting sub-segment 111. That is, the width of the third connecting sub-segment 113 is greater than the width of the second connecting sub-segment 112, so as to increase the contact area between the edge solder joint 13 and the first finger 11, thereby facilitating improvement of the soldering strength of the solder joint, reduction of the risk of electrical connection failure of the back-contact solar cell 10, and further improvement of the reliability of the back-contact solar cell 10.

As shown in FIG. 5, in one or more embodiments, the area of the edge solder joint 13 is greater than the area of the middle solder joint 14.

Also as shown in FIG. 1, during the production and operation of the back-contact solar cell 10, the edge region of the back-contact solar cell 10, especially the corner parts thereof, have to bear greater stress. Therefore, the corner parts of the back-contact solar cell 10 are prone to warping deformation and other conditions, thereby affecting the stability of the arrangement of the edge solder joint 13. By increasing the area of the edge solder joint 13, it is enabled to effectively disperse stress and improve the fatigue resistance, thereby reducing the risk of cracking of the edge solder joint 13, providing a reliable soldering point for the solder strip, improving the soldering strength, and further improving the stability and reliability of the connection between the solder strip and the back-contact solar cell 10. In addition, increasing the area of the edge solder joint 13 also improves its current transmission capability, so that the current is more efficiently and stably transmitted to the solder strip through the edge solder joint 13, thereby improving the electrical property of the back-contact solar cell 10.

As an example, the area S1 of the edge solder joint 13 satisfies: 0.25 mm² ≤ S1 ≤ 4 mm². For example, S1 may be 0.25 mm², 0.05 mm², 0.1 mm², 0.5 mm², 1 mm², 2 mm², 3 mm², 3.5 mm² or 4mm², or other value within the above range. By limiting the area of the edge solder joint 13, the reliability of the edge solder joint 13 is improved, the risk of cracking thereof is reduced, and its current transmission capability is increased, thereby improving the reliability of the back-contact solar cell 10.

As an example, the area S2 of the middle solder joint 14 satisfies: 0.1 mm² ≤ S2 ≤ 0.7 mm². For example, S2 may be 0.1 mm², 0.2 mm², 0.3 mm², 0.4 mm², 0.5 mm², 0.6 mm², or 0.7 mm², or other value within the above range. By limiting the area of the middle solder joint 14, its light-shading area is reduced, and the stability and reliability of the connection between the middle solder joint 14 and the solder strip are ensured, thereby ensuring the normal and stable transmission of current.

As shown in FIG. 5, in one or more embodiments, in the first direction X, the size of the edge solder joint 13 is greater than the size of the middle solder joint 14. In the second direction Y, the size of the edge solder joint 13 is equal to the size of the middle solder joint 14.

By increasing the size of the edge solder joint 13 in the first direction X, its area is larger than the area of the middle solder joint 14, so that the shape of the edge solder joint 13 is better match the shape of the solder strip (not shown in the figure), improving the contact area between the edge solder joint 13 and the solder strip, thereby improving the stability and reliability of the connection between the edge solder joint 13 and the solder strip.

As an example, in the first direction X, the ratio of the size D1 of the edge solder joint 13 to the size D2 of the middle solder joint 14 satisfies: 2 ≤ D1/D2 ≤ 15. For example, the ratio of D1 to D2 may be 2, 3, 4, 5, 6, 7, 8, 9, 10, 11 12, 13, 14, or 15. By limiting the size proportion of the edge solder joint 13 and the middle solder joint 14 in the first direction X, the area ratio of the edge solder joint 13 and the middle solder joint 14 is maintained within a reasonable range, so that the solder strip is stably and reliably connected to the edge solder joint 13 and the middle solder joint 14, thereby realizing normal and stable transmission of current.

As mentioned above, the back-contact solar cell includes a first finger and a second finger. The second finger and the first finger are arranged alternately in the first direction, and have opposite polarities. As shown in FIG. 5, in which taking the third side edge 10c as an example to schematically show the edge of the back-contact solar cell 10. In one or more embodiments, the edge solder joint 13 includes a first extension part 135 and a second extension part 136 in the first direction X. The first extension part 135 is located in the first insulation space 121 formed by cutting the second finger 12, and the second extension part 136 is located in the second insulation space 122 formed by cutting the second finger 12. The second finger 12 at a side of the first insulation space 121 closed to the edge of the back-contact solar cell 10 is electrically connected to the second finger 12 adjacent thereto through the third connecting wire 17. The second finger 12 at a side of the second insulation space 122 closed to the edge of the back-contact solar cell 10 is electrically connected to the second finger 12 adjacent thereto through the third connecting wire 17.

The first extension part 135 is connected to the first connecting wire 15, and the second extension part 136 is connected to the second connecting wire 16. The second finger 12 includes a first part 123, a second part 124, a third part 125, and a fourth part 126. The first part 123 and the second part 124 are arranged in the second direction Y. The first insulation space 121 is located between the first part 123 and the second part 124. At least part structure of the first extension part 135 is located in the first insulation space 121 and has a certain interval with the first part 123 and the second part 124 of the second finger 12. The first part 123 is located at a side of the first insulation space 121 closed to the edge of the back-contact solar cell 10. The first part 123 is electrically connected to another second finger 12 adjacent thereto through the third connecting wire 17, that is, the third connecting wire 17 is electrically connected to two adjacent second fingers 12.

The third part 125 and the fourth part 126 are arranged in the second direction Y. The second insulation space 122 is located between the third part 125 and the fourth part 126. A part structure of the second extension part 136 is located in the second insulation space 122 and has a certain interval with the third part 125 and the fourth part 126 of the second finger 12. The third part 125 is located at a side of the second insulation space 122 closed to the edge of the back-contact solar cell 10. The third part 125 is electrically connected to another second finger 12 adjacent thereto through the third connecting wire 17.

The third connecting wire 17 is formed by printing metal paste and then drying and sintering.

As mentioned above, the edge solder joint 13 increases its own area by increasing its size in the first direction X. Therefore, the first extension part 135 and the second extension part 136 of the edge solder joint 13 extend outward in the first direction X. That is, the first extension part 135 and the second extension part 136 respectively extend toward the first insulation space 121 and the second insulation space 122. The first insulation space 121 and the second insulation space 122 are respectively formed by cutting the corresponding second fingers 12. The first insulation space 121 and the second insulation space 122 play a role of avoiding the edge solder joint 13 to provide sufficient space for the arrangement of the edge solder joint 13. In addition, since the edge solder joint 13 is electrically connected to the first finger 11, the first insulation space 121 and the second insulation space 122 further play a role of insulating the edge solder joint 13, to reduce the risk of short circuit of the back-contact solar cell 10 caused by the contact between the edge solder joint 13 and the second finger 12, thereby ensuring the normal and stable operation of the back-contact solar cell 10. The third connecting wire 17 realizes electrical connection between two adjacent second fingers 12, reducing the possibility that the current in the second finger 12 cannot be transmitted due to the arrangement of the first insulation space 121 and the second insulation space 122, thereby reducing the possibility of local current loss in the back-contact solar cell 10, and further improving the reliability of the back-contact solar cell.

A third insulation space 114 and a fourth insulation space 115 are formed at the cut parts of the first finger 11. Two third connecting wires 17 respectively pass through the corresponding insulation spaces to realize electrical connection between the adjacent second fingers 12. The third insulation space 114 and the fourth insulation space 115 play a role of insulating the third connecting wire 17, reducing the possibility of short circuit of the back-contact solar cell 10 due to the connection between the third connecting wire 17 and the first finger 11.

As shown in FIG. 6, one or more embodiments of the present disclosure provides a tandem solar cell 20, including a crystalline silicon bottom cell 21 and a perovskite top cell 22. The crystalline silicon bottom cell 21 includes the back-contact solar cell described above, and the perovskite top cell 22 is electrically connected to the crystalline silicon bottom cell 21.

The perovskite top cell 22 includes a substrate, a conductive film, an electron transport layer (e.g., titanium dioxide), a perovskite absorption layer, a hole transport layer, and a metal electrode (not shown in the figure). The perovskite material has a high light absorption coefficient and a long carrier diffusion distance. Upon the photons absorbed by the perovskite material being converted electrons, they are easily collected with lower loss by an electrode, thereby generating a high photovoltage and photocurrent, to enable the perovskite top cell 22 to exhibit a high photoelectric conversion efficiency.

By combining the back-contact solar cell described above with the perovskite cell to form a tandem cell, an absorption of a broader range of the solar spectrum is realized, thereby improving the photoelectric conversion efficiency of the tandem cell. Since the back-contact solar cell processes the above technical effects, the tandem module having the back-contact solar cell also processes the above technical effects, which will not be repeated herein.

As shown in FIG. 7, one or more embodiments of the present disclosure provides a photovoltaic module 1000, including a cover plate, an encapsulation layer, and a solar cell string 100. The solar cell string 100 includes a plurality of the back-contact solar cells described above, or the solar cell string 100 includes a plurality of the tandem solar cells 20 described above.

The cover plate located at the top of the photovoltaic module 1000 is a first cover plate 200. The cover plate located at the bottom of the photovoltaic module 1000 is a second cover plate 300. The encapsulation layer located between the first cover plate 200 and the solar cell string 100 is a first encapsulation layer 400. The encapsulation layer located between the second cover plate 300 and the solar cell string 100 is a second encapsulation layer 500. The first cover plate 200, the first encapsulation layer 400, the solar cell string 100, the second encapsulation layer 500, and the second cover plate 300 are arranged in the thickness direction Z of the photovoltaic module 1000 and laminated together. The first cover plate 200 is a glass cover plate with a high light transmittance. The first encapsulation layer 400 bonds the first cover plate 200 and the solar cell string 100 together to provide encapsulation and protection for the solar cell string 100. The material of the first encapsulation layer 400 is one or more of ethylene-vinyl acetate copolymer (EVA), polyolefin elastomer (POE), and polyvinyl butyral (PVB). The second encapsulation layer 500 connects the solar cell layer and the second cover plate 300 together, which also provides encapsulation and protection for the solar cell string 100. The material of the second encapsulation layer 500 is one or more of EVA, POE, and PVB described above. The material of the second cover plate 300 is glass, or the second cover plate 300 is formed by compounding a plurality of polymer film layers.

The above descriptions are only optional embodiments of the present disclosure and are not intended to limit the present disclosure, and various modifications and changes may be made by those skilled in the art. The scope of the present disclosure shall be defined by the appended claims.

## Claims

1. A back-contact solar cell (10), **characterized in that** the back-contact solar cell (10) comprises:
a first finger (11), wherein a plurality of the first fingers (11) are arranged in a first direction;
an edge solder joint (13), located at an edge of the back-contact solar cell (10) and arranged on the first finger (11); and
a middle solder joint (14), wherein a plurality of the middle solder joints (14) are arranged between two adjacent edge solder joints (13) in the first direction, and are respectively arranged on the corresponding first fingers (11),
wherein edge solder joint (13) comprises a first end (131) facing the middle solder joint (14) and a second end (132) away from the middle solder joints (14) in the first direction, wherein the first end (131) is electrically connected to the middle solder joint (14) adjacent thereto through a first connecting wire (15), the second end (132) is electrically connected to the first finger (11) adjacent thereto through a second connecting wire (16), and a width of the second connecting wire (16) is greater than a width of the first connecting wire (15).

2. The back-contact solar cell (10) according to claim 1, **characterized in that** a width W1 of the first connecting wire (15) satisfies: 5 µm ≤ W1 ≤ 20 µm; and/or
a width W2 of the second connecting wire (16) satisfies: 100 µm ≤ W2 ≤ 300 µm.

3. The back-contact solar cell (10) according to claim 1, **characterized in that** the first finger (11) connected to the edge solder joint (13) comprises a first connecting sub-segment (111) and a second connecting sub-segment (112); and
wherein the edge solder joint (13) comprises a third end (133) facing the edge of the back-contact solar cell (10) and a fourth end (134) away from the edge of the back-contact solar cell (10) in a second direction, and wherein the first connecting sub-segment (111) is located at a side of the third end (133) and extends in the second direction to the edge of the back-contact solar cell (10), the second connecting sub-segment (112) is located at a side of the fourth end (134) and extends in the second direction away from the first connecting sub-segment (111), and a width of the first connecting sub-segment (111) is greater than a width of the second connecting sub-segment (112).

4. The back-contact solar cell (10) according to claim 3, **characterized in that** a width W3 of the first connecting sub-segment (111) satisfies: 100 µm ≤ W3 ≤ 350 µm; and/or
a width W4 of the second connecting sub-segment (112) satisfies: 5 µm ≤ W4 ≤ 20 µm.

5. The back-contact solar cell (10) according to claim 3, **characterized in that** a length L1 of the first connecting sub-segment (111) satisfies: 4 mm ≤ L1 ≤ 6 mm.

6. The back-contact solar cell (10) according to claim 3, **characterized in that** the first finger (11) connected to the edge solder joint (13) comprises a third connecting sub-segment (113), wherein in the second direction, the third connecting sub-segment (113) is connected between the first connecting sub-segment (111) and the second connecting sub-segment (112);
wherein the third connecting sub-segment (113) is connected to the edge solder joint (13), and a projection of the third connecting sub-segment (113) in a third direction is located within the edge solder joint (13); and
wherein a width of the third connecting sub-segment (113) is equal to the width of the first connecting sub-segment (111), or the width of the third connecting sub-segment (113) is equal to the width of the second connecting sub-segment (112).

7. The back-contact solar cell (10) according to any one of claims 1 to 6, **characterized in that** an area of the edge solder joint (13) is larger than an area of the middle solder joint (14).

8. The back-contact solar cell (10) according to claim 7, **characterized in that** in the first direction, a size of the edge solder joint (13) is greater than a size of the middle solder joint (14); and
in the second direction, a size of the edge solder joint (13) is equal to a size of the middle solder joint (14).

9. The back-contact solar cell (10) according to claim 8, **characterized in that** the back-contact solar cell (10) comprises: second finger (12), wherein the second finger (12) and the first finger (11) are arranged alternately in the first direction, and the first finger (11) and the second finger (12) have opposite polarities,
wherein the edge solder joint (13) comprises a first extension part (135) and a second extension part (136) in the first direction, wherein at least part structure of the first extension part (135) is located in a first insulation space (121) formed by cutting the second finger (12), and at least part structure of the second extension part (136) is located in a second insulation space (122) formed by cutting the second finger (12),
wherein the second finger (12) at a side of the first insulation space (121) closed to an edge of the back-contact solar cell (10) is electrically connected to the second finger (12) adjacent thereto through a third connecting wire (17), and
wherein the second finger (12) at a side of the second insulation space (122) closed to an edge of the back-contact solar cell (10) is electrically connected to the second finger (12) adjacent thereto through a third connecting wire (17).

10. The back-contact solar cell (10) according to claim 13, **characterized in that** the second finger (12) comprises a first part (123), a second part (124), a third part (125), and a fourth part (126),
wherein the first part (123) and the second part (124) are spaced apart in the second direction, and the first insulation space (121) is located between the first part (123) and the second part (124), and
wherein the third part (125) and the fourth part (126) are spaced apart in the second direction, and the second insulation space (122) is located between the third part (125) and the fourth part (126).

11. The back-contact solar cell (10) according to claim 14, **characterized in that** the first connecting wire (15) passes through the first insulation space (121) in the first direction to realize electrical connection between the edge solder joint (13) and the middle solder joint (14) adjacent thereto, and wherein a part of the structure of the first connecting wire (15) is located within the first insulation space (121) and has an interval with the first part (123) and the second part (124) of the second finger (12), and/or
the second connecting wire (16) passes through the second insulation space (122) to realize the electrical connection between the edge solder joint (13) and the first finger (11) adjacent thereto, and wherein a part of the structure of the second connecting wire (16) is located within the second insulation space (122) and has a certain interval with the third part (125) and the fourth part (126) of the second finger (12).

12. The back-contact solar cell (10) according to claim 13, **characterized in that** the first extension part (135) is connected to the first connecting wire (15), and the second extension part (136) is connected to the second connecting wire (16).

13. The back-contact solar cell (10) according to claim 13, **characterized in that** the first finger (11) comprises a third insulation space (114) and a fourth insulation space (115), wherein two third connecting wires (17) respectively pass through the corresponding third insulation space (114) and fourth insulation space (115) to realize electrical connection between two adjacent second fingers (12).

14. A tandem solar cell (20), **characterized in that** the tandem solar cell (20) comprises:
a crystalline silicon bottom cell (21) comprising the back-contact solar cell (10) according to any one of claims 1 to 9; and
a perovskite top cell (22) electrically connected to the crystalline silicon bottom cell (21).

15. A photovoltaic module (1000), **characterized in that** the photovoltaic module (1000) comprises a cover plate, an encapsulation layer, and a solar cell string (100), wherein the solar cell string (100) comprises a plurality of the back-contact solar cells (10) according to any one of claims 1 to 9, or the solar cell string (100) comprises a plurality of the tandem solar cells (20) according to claim 10.
